# EUROPEAN PATENT SPECIFICATION

(11) **EP 4 466 499 B1**
(45) Date of publication and mention of the grant of the patent: **08.10.2025**
(21) Application number: 23713036.4
(22) Date of filing: 13.01.2023
(51) Int. Cl.: F24S 20/50, H02S 20/30, F24S 30/452

(54) **MOBILE FOLDING CONCENTRATING SOLAR POWER PLANT**
MOBILES FALTBARES KONZENTRIERENDES SOLARKRAFTWERK
CENTRALE SOLAIRE À CONCENTRATION MOBILE PLIABLE

(30) Priority: 20.01.2022 CZ 20220025
(43) Date of publication of application: 27.11.2024
(73) Proprietor: Strojirny Bohdalice A.S., 68341 Bohdalice-Pavlovice (CZ)
(72) Inventor: ONDRASEK, Dusan, 68734 Uhersky Brod (CZ); BROZ, Josef, 26801 Felbabka (CZ); MICHALOV, Martin, 26801 Horovice (CZ)
(74) Representative: Tomickova, Dana
(86) International application number: PCT/CZ2023/050004
(87) International publication number: WO 2023/138710

(56) References cited:
- WO-A1-2017/044911
- WO-A2-2010/039999
- WO-A2-2013/115832
- US-A1- 2013 186 450
- US-A1- 2015 059 825

## Description

### Background of the Invention

The present invention concerns a mobile folding concentrating solar power plant.

### State of the art

According to the current state of the art, a mobile folding concentrating solar power plant comprises:
- a solid building foundation with a flange for connecting the power plant, which is usually a reinforced concrete structure placed in the ground, dimensioned according to the standards, soil bearing capacity, wind speed, etc., designed and implemented according to an authorized project documentation,
- a solid part of a column, which is a steel weldment firmly connected to the building foundation,
- an electromechanical drive ensuring azimuth tracking of the sun, which is firmly connected to the solid column,
- a rotational part of the column, which is a steel weldment firmly connected to the output of the azimuth drive,
- an electromechanical drive ensuring the elevation tracking of the sun, which is firmly connected to a rotating column,
- an arm of a concentrator, i.e. a steel lattice structure, firmly connected to the output of an elevation drive,
- an electrical conversion unit, so-called "power conversion unit", firmly mounted at the end of the concentrator arm so that a receiver of a Stirling engine is in a suitable position near the focus point of the concentrator, and
- a mirror concentrator, which is a steel structure carrying individually adjustable mirrors.

Disadvantage of the state of the art is, that for the concept of the solid building foundation a geological exploration directly at the installation site and remote coordination of preparatory construction work is required. Furthermore, it brings logistics problems and time-consuming construction of the foundation, limited possibilities for building construction on a slope and on rugged terrain, furthermore, for the foundation of the building is required the knowledge of a local legislation relating in particular to buildings firmly connected to the ground, their permitting, etc. Another disadvantage is that the assembly of the whole power plant, mirror adjustment, electrical installation and commissioning, has to be carried out on the site by highly specialized workers, and high transport costs (several 40" containers for one power plant). Furthermore, there is need to use a crane, which is a complication especially for remote regions, and complex and precise technological installation and assembly procedure is also necessary, while the high time-consuming installation is further negatively affected by current conditions, such as wind, intensity of solar radiation, rain, etc.
Document WO 2010/039999 discloses a foldable concentrating solar power plant placed on a trailer.

The aim of the invention is to present a solution, where above mentioned disadvantages of the state of the art are eliminated.

### Feature of the Invention

The above mentioned disadvantages are considerably eliminated by a mobile folding concentrating solar power plant, which comprises a container with a supporting base, to which one end of a supporting column is connected by means of a rotary link, wherein an arm is connected to the other end of the supporting column via a multiaxis joint, which arm is equipped with a concentrator with mirrors and with an electrical conversion unit, where the multi-axis joint contains an elevation drive with a horizontal axis of rotation and an azimuthal drive with a vertical axis of rotation, where the electrical conversion unit is positioned so, that when the folding concentrating solar power plant is unfolded, it is placed in the optical axis of the concentrator, and after unfolding the mirrors are adjusted in the such way, that the reflections of the sun rays reflected by all the mirrors are directed to the electric conversion unit during tracing of the sun, where the concentrator comprises two main side parts, which are hinged with respect to the arm around pin joints so that when folded, it adjoins the arm.

In an advantageous embodiment each main side part comprises a central part, which is foldable with respect to the arm around pin joints, and further comprises upper and/or lower parts, which are rotatably connected to the central part by means of a pin joint, the axis of which is perpendicular to the axis of the pin joints between the central part and the arm.

In another advantageous embodiment the arm is designed as a lattice steel assembled or welded structure.

### Description of the drawings

The invention will be further explained using the drawings, where Fig. 1 represents the mobile folding concentrating solar power plant according to the invention in the transport state, Fig. 2 represents a front view of the mobile folding concentrating solar power plant according to the invention in the unfolded state, and Fig. 3 represents a rear view of the mobile folding concentrating solar power plant according to the invention in the unfolded state.

### Preferred embodiments of the invention

The mobile folding concentrating solar power plant according to the invention comprises a container with a supporting base 1a, to which one end of a supporting column 3 is connected by means of a rotational connection, e.g. a bearing, to which an arm 4 is connected at the other end via a multi-axial joint, which is equipped with a concentrator with mirrors 8 and an electric conversion unit 9.

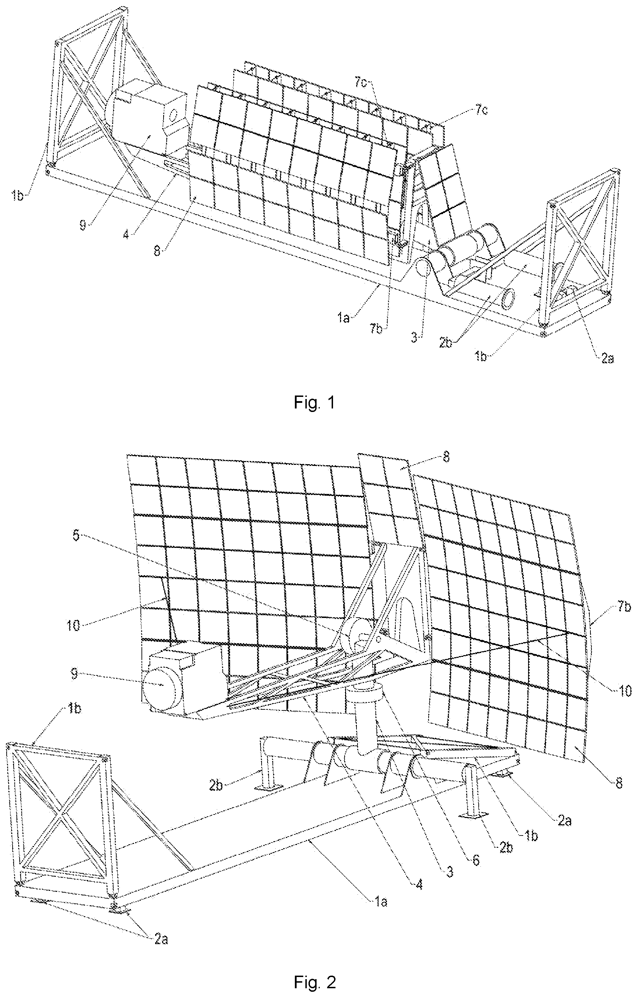

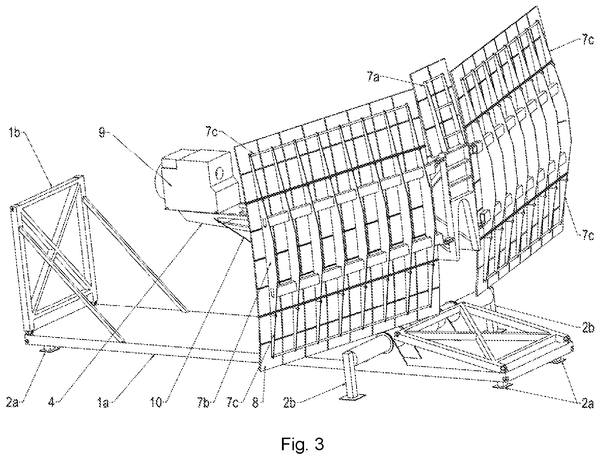

The mobile folding concentrating solar power plant according to the invention in the transport state is presented in Fig. 1, where the container is indicated only by reinforcements of the front walls. The mobile folding concentrating solar power plant according to the invention is presented in Fig. 2 and 3 in the unfolded state.

The electrical conversion unit 9 is located at the optical axis of the concentrator, whose mirrors 8 are adjusted after its unfolding, so that sun ray's reflections by the mirrors 8 are directed to the conversion unit 9 during tracking of the sun.

In an exemplary embodiment, the concentrator structure comprises two main side parts, which are foldable with respect to the arm 4 around the pin joints, so that it adjoins the arm 4 when folded.

According to another embodiment, each of the main side parts is formed by central part 7b, which is hinged with respect to the arm 4 around the pin joints, see above, and further comprises an upper and a lower part 7c, which are rotatably connected to the central part 7b by means of a pin joint, where its axis is perpendicular to the axis of the pin joints between the central part 7b and the arm 4. Because of that, reduction of the construction height and transportation after folding are possible.

Preferably, the concentrator structure comprises an additional part 7a, which is located on the upper part of the arm 4 between the main side parts, where the additional part 7a is foldable with respect to the arm 4 around pins, whose axis is parallel to the axis of the elevation drive 5. All parts of the concentrator are located on the opposite side of the arm 4 then where the electrical conversion unit 9 is located.

The arm 4 is constructed as a lattice steel assembled or welded structure.

The multi-axis joint is equipped with an elevation drive 5 and an azimuthal drive 6. The elevation drive 5 has a horizontal axis of rotation, and the azimuthal drive 6 has a vertical axis of rotation.

The mirrors 8 are arranged on the concentrator structure and are adjusted to a position, which enables the correct concentration of the solar radiation after its unfolding, see above, before being folded into the container ready for transport.

The electrical conversion unit 9 is identical to the device known from the prior art, but it is firmly arranged on the arm 4 already before transportation. The electric conversion unit 9 can be remounted/mounted without use of a crane, which is ensured by appropriate kinematics of the arm 4 and required range of movements of the drives 5, 6.

Electrical installation is arranged mainly in the supporting base 1a. The same applies for a thermal output.

The container is a standardized or specially designed sea container with maximum external dimensions corresponding to the type 1AAA according to the standard ISO 668:2020, so-called 40" HIGH CUBE container, which is directly transportable by truck to an installation site. It is possible to fold it from the truck without help of a crane. No demanding terrain preparation is required. The container is only leveled and secured against shifting and overturning, e.g. by separately adjustable legs. In this particular case, four longitudinal legs 2a in the corners of the supporting base 1a, which balance in the longitudinal direction, and two transverse legs 2b on the sides of the supporting base 1a, which balance in the transverse direction are presented. Because of that, the supporting base 1a is sufficient replacement of a solid construction foundation of the state of the art. Optionally, its cover is made of sheet metal parts, wooden panels from car tarpaulin in combination with wooden or metal supporting profiles. Advantageously, most of the container elements could be used as a supporting structure for another optionally installed photovoltaic panels intended for additional increase of output of the power plant, i.e. PV panels intended to increase output can be placed and integrated on the container. Screws, pins and welded connections are possibly used.

Unfolding of the mobile folding concentrating solar power plant according to the invention into working condition is carried out in the following way:
- The container is arranged in the desired place and leveled by adjustable legs 2a, 2b.
- The sides and the ceiling of the container are dismantled.
- The front 1b of the container, which is closer to the column 3, is tilted so that during any positioning of the concentrator within the permitted ranges of the drives 5, 6, this front 1b cannot collide with the concentrator or the mirrors 8. The front 1b of the container is lowered by use of hydraulic cylinders or other mechanization - by rotation around a pivot joint between the supporting base 1a and the front 1b. The pair of the hydraulic cylinders can be transferable and used for other operations described below.
- The column 3 is erected, which is realized advantageously by means of the elevation drive 5 by its rotation between the arm 4 and the column 3, whereby the arm 4 is suitably guided along the supporting base 1a. An auxiliary mechanical winch can also be used to reduce load. When the vertical position of the column 3 is achieved, it is mechanically secured against the supporting base 1a. However, the arm 4 is still in contact with the supporting base 1a.
- The arm 4 is moved to a horizontal position using the elevation drive 5.
- Both halves of the concentrator structure with the mirrors 8, while simultaneously rotating around the pivot joint between the arm and the concentrator structure, are tilted out by use of pair of hydraulic cylinders, and secured with a screw or other detachable connection.
- Subsequently, the upper and the lower parts 7c (if they are part of a specific embodiment) are gradually folded around pin joints, which are parts of the concentrator structure, and then secured in the working positions with a screw or other detachable connection. Folding is always performed in each step by a pair of hydraulic cylinders. In this step, gravity and the elevation drive 5 can advantageously be used.

The entire structure allows various solutions of assembled, riveted and welded parts from different types of semi-finished products and materials, taking into account the specific location of the installation and its marginal conditions (wind speed, snow map, seismic load, temperature ranges, air humidity and altitude).

The column 3, the arm 4 and the concentrator structure with the mirrors 8 carry out sliding, rotational or even general spatial movement, when being unfolded into the working position. They are positioned, for example using their own drives, preferably only the elevation drive 5 or additional handling elements, which work by use of hydraulics, pneumatics, electromechanical hoists, winches, etc.

During the unfolding process, the individual parts are gradually secured in their working positions, for example by means of repeatedly detachable connections. Advantageously, reinforcement to increase rigidity by use of steel cables 10 is possible.

The advantage of the above-mentioned solution is its possible pre-assembling directly by the manufacturer, even before the technology is shipped to a customer. The number of necessary activities, workers, technology and time, and thus the total costs for its implementation, at the installation site are reduced to maximum. The principle of the construction makes for easy and quick disassembly and reassembly at another place of use. The principle of the construction fundamentally facilitates implementation in hard-toreach and remote locations, where it is not technically or economically possible to move various special equipment, e.g. drilling rigs, an excavation equipment, a truck mixer with a concrete pump or truck cranes. Because of the mobility, the principle of this construction does not require to get a permission related to buildings, which are connected to the ground by a solid foundation. The principle of this construction reduces demands and costs of transportation and, ultimately, the entire carbon footprint associated with the production and operation of this technology.

## Claims

1. Mobile folding concentrating solar power plant, **characterized in, that**
- it comprises a container with a supporting base (1a), to which one end of a supporting column (3) is connected by means of a rotary link, wherein an arm (4) is connected to the other end of the supporting column (3) via a multiaxis joint, the arm (4) being equipped with a concentrator with mirrors (8) and with an electrical conversion unit (9),
- where the multi-axis joint contains an elevation drive (5) with a horizontal axis of rotation and an azimuthal drive (6) with a vertical axis of rotation,
- where the electrical conversion unit (9) is positioned so that when the folding concentrating solar power plant is unfolded, the electrical conversion unit (9) is placed in the optical axis of the concentrator, and after unfolding, the mirrors (8) are adjusted in such a way, that reflections of sun rays reflected by all the mirrors (8) are directed to the electric conversion unit (9) during tracing of the sun,
- where the concentrator comprises two main side parts, which are hinged with respect to the arm (4) around pin joints, so that when folded, it adjoins the arm (4).

2. Mobile folding concentrating solar power plant according to claim 1, **characterized in, that** each main side part comprises a central part (7b), which is foldable with respect to the arm (4) around pin joints, and further comprises upper and/or lower parts (7c), which are rotatably connected to the central part (7b) by means of a pin joint, the axis of which is perpendicular to the axis of the pin joints between the central part (7b) and the arm (4).

3. Mobile folding concentrating solar power plant according to any of the claims 1 or 2, **characterized in, that** the arm (4) is designed as a lattice steel assembled or welded structure.

## Patentansprüche

1. Ein mobiles faltbares konzentrierendes Solarkraftwerk, **dadurch gekennzeichnet, dass**
- es einen Behälter mit einem Tragboden (1 a) umfasst, mit dem ein Ende einer Tragsäule (3) über eine Drehverbindung verbunden ist, wobei ein Arm (4) über ein mehrachsiges Gelenk mit dem anderen Ende der Tragsäule (3) verbunden ist, wobei der Arm (4) mit einem Konzentrator mit Spiegeln (8) und mit einer elektrischen Umwandlungseinheit (9) versehen ist,
- wobei das mehrachsige Gelenk einen Elevationsantrieb (5) mit einer horizontalen Drehachse und einen azimutalen Antrieb (6) mit einer vertikalen Drehachse umfasst,
- wobei die elektrische Umwandlungseinheit (9) so positioniert ist, dass beim Entfalten des faltbaren konzentrierenden Solarkraftwerks die elektrische Umwandlungseinheit (9) in der optischen Achse des Konzentrators platziert wird und nach dem Entfalten die Spiegel (8) so eingestellt werden, dass Reflexionen von Sonnenstrahlen, die von allen Spiegeln (8) reflektiert werden, während der Verfolgung der Sonne zur elektrischen Umwandlungseinheit (9) geleitet werden,
- wobei der Konzentrator zwei Hauptseitenteile umfasst, die um Stiftgelenke gegenüber dem Arm (4) angelenkt sind, so dass er sich im gefalteten Zustand an den Arm (4) anschließt.

2. Das mobile faltbare konzentrierende Solarkraftwerk nach Anspruch 1, **dadurch gekennzeichnet, dass** jedes Hauptseitenteil ein Mittelteil (7b) umfasst, das gegenüber dem Arm (4) um Stiftgelenke faltbar ist, und ferner Ober- und/oder Unterteile (7c) umfasst, die über ein Stiftgelenk drehbar mit dem Mittelteil (7b) verbunden sind, dessen Achse senkrecht zur Achse der Stiftgelenke zwischen dem Mittelteil (7b) und dem Arm (4) ist.

3. Das mobile faltbare konzentrierende Solarkraftwerk nach einem der Ansprüche 1 oder 2, **dadurch gekennzeichnet, dass** der Arm (4) als Gitterstahl- oder Schweißkonstruktion ausgebildet ist.

## Revendications

1. Une centrale solaire à concentration mobile pliable, **caractérisée en ce que**
- elle comprend un récipient avec une base de support (1 a), à laquelle une extrémité d'une colonne de support (3) est reliée au moyen d'une liaison rotative, où un bras (4) est relié à l'autre extrémité de la colonne de support (3) au moyen d'une articulation à axes multiples, où le bras (4) est équipé d'un concentrateur avec des miroirs (8) et d'une unité de conversion électrique (9),
- où l'articulation à axes multiples comprend un entraînement d'élévation (5) avec un axe de rotation horizontal et un entraînement azimutal (6) avec un axe de rotation vertical,
- où l'unité de conversion électrique (9) est positionnée de telle sorte que, lorsque la centrale solaire à concentration pliable est dépliée, l'unité de conversion électrique (9) est placée dans l'axe optique du concentrateur, et après le dépliage, les miroirs (8) sont ajustés de telle sorte que des réflexions de rayons solaires réfléchis par tous les miroirs (8) sont dirigées vers l'unité de conversion électrique (9) pendant le traçage du soleil,
- où le concentrateur comprend deux parties latérales principales, qui sont articulées par rapport au bras (4) autour d'articulations à broche, de sorte que lorsqu'il est plié, il est adjacent au bras (4).

2. La centrale solaire à concentration mobile pliable selon la revendication 1, **caractérisée en ce que** chaque partie latérale principale comprend une partie centrale (7b), qui est pliable par rapport au bras (4) autour d'articulations à broche, et comprend en outre des parties supérieure et/ou inférieure (7c), qui sont reliées de manière rotative à la partie centrale (7b) au moyen d'une articulation à broche, dont l'axe est perpendiculaire à l'axe des articulations à broche entre la partie centrale (7b) et le bras (4).

3. La centrale solaire à concentration mobile pliable selon l'une quelconque des revendications 1 ou 2, **caractérisée en ce que** le bras (4) est conçu sous la forme d'une structure assemblée ou soudée en acier en treillis.
